Europäisches Patentamt

(19) European Patent Office

Office européen des brevets

(11) Veröffentlichungsnummer: **0 321 856 B1**

(12) **EUROPÄISCHE PATENTSCHRIFT**

(45) Veröffentlichungstag der Patentschrift:
18.09.91 Patentblatt 91/38

(51) Int. Cl.$^5$: **C23C 18/20**

(21) Anmeldenummer: 88120959.7

(22) Anmeldetag: 15.12.88

(54) **Polymere Konditionierungsmittel zur Vorbehandlung von nichtmetallischen Oberflächen für eine chemische Metallisierung.**

(30) Priorität: 23.12.87 DE 3743743

(43) Veröffentlichungstag der Anmeldung:
28.06.89 Patentblatt 89/26

(45) Bekanntmachung des Hinweises auf die
Patenterteilung:
18.09.91 Patentblatt 91/38

(84) Benannte Vertragsstaaten:
CH DE ES FR GB IT LI NL SE

(56) Entgegenhaltungen:
EP-A- 0 100 452
DE-A- 3 213 771
GB-A- 2 154 251

(73) Patentinhaber: BASF Aktiengesellschaft
Carl-Bosch-Strasse 38
W-6700 Ludwigshafen (DE)

(72) Erfinder: Tschang, Chung-Ji, Dr.
Hinterbergstrasse 31
W-6702 Bad Duerkheim (DE)
Erfinder: Dix, Johannes Peter, Dr.
Ludwigshafener Strasse 125
W-6708 Neuhofen (DE)
Erfinder: Winkler, Ekhard, Dr.
Pfalzring 74
W-6704 Mutterstadt (DE)
Erfinder: Gotsmann, Guenther, Dr.
Max-Beckmann-Strasse 15
W-6710 Frankenthal (DE)
Erfinder: Glaser, Klaus
Neuweg 14
W-6704 Mutterstadt (DE)
Erfinder: Fikentscher, Rolf, Dr.
Von-Stephan-Strasse 27
W-6700 Ludwigshafen (DE)

**Beschreibung**

Die Erfindung betrifft die Verwendung von Salzen quaternäre Gruppen enthaltender Polykondensate aus Di- und/oder Tri-(alkanol)-aminen als Konditionierungsmittel zur Vorbehandlung nichtmetallischer Oberflächen von Formkörpern vor ihrer Bekeimung für eine nachfolgende vollständige und gleichmäßige Metallisierung.

Die chemische Metallisierung der Oberfläche von nichtmetallischen Materialien dient in der Regel der Erzielung eines dekorativen Effekts, dem Schutz der Materialoberfläche oder aber der Erzielung einer elektrischen Leitfähigkeit der Oberfläche. Beispiele hierfür sind die Vernickelung (mit anschließender galvanischer Verchromung) von Kunststoffteilen im Automobilbau sowie die chemische Verkupferung von Leiterplatten für elektrotechnische und elektronische Geräte. Die chemische Metallisierung wird in mehreren Schritten durchgeführt. Im Falle der chemischen Verkupferung von Leiterplatten (vor allem zur Durchkontaktierung von Bohrlöchern) sind dies die Reinigung, die Anätzung der Kupfer-Kaschierung, das sogenannte "Pre-dip" zum Schutz des nachfolgenden Bades, die Bekeimung mit einem Palladium- oder Kupfer-Kolloid (auch "Aktivierung" genannt), die Entfernung überschüssigen Kolloids (auch "Strippen" genannt) und schließlich die eigentliche chemische Verkupferung. Dabei wird ein gleichmäßiger und vollständiger Kupferbelag angestrebt. Erfahrungsgemäß treten bei der Verkupferung von Bohrlöchern bisweilen Störungen auf, welche darin bestehen, daß die im Bohrloch chemisch abgeschiedene Kupferhülse kleine Löcher aufweist oder aber an einer oder an mehreren Stellen nicht am Grundmaterial der Leiterplatte haftet (Lochwand-Ablösung), was beim Einlöten von Bauteilen zu fehlerhaften Kontakten führt. Auch bei der Beschichtung nichtmetallischer Oberflächen mit anderen Metallen kann es zu ähnlichen Störungen kommen. Es ist somit nötig, bei der chemischen Verkupferung und naturgemäß auch bei den anderen chemischen Metallisierungen eine möglichst gute Porenfreiheit und Haftung zu erzielen.

Dies ist nur dann gewährleistet, wenn bei der Bekeimung die zu metallisierende Oberfläche gleichmäßig mit Kolloid belegt werden kann. Bei glasfaserverstärkten Epoxidharzplatten beispielsweise ist dies jedoch häufig nicht der Fall, da Fasern des Laminats in das Bohrloch hineinragen, wodurch die Bildung von Schwachstellen oder gar Löchern im abgeschiedenen Kupfer hervorgerufen wird.

Die Bekeimung der Oberfläche mit Kolloid kann verbessert werden, wenn der zu metallisierende Gegenstand mit einem Konditionierungsmittel vorbehandelt wird. Dieses Mittel hat die Aufgabe, die Benetzbarkeit der Oberfläche und die Adsorptionsfähigkeit gegenüber dem Kolloid zu verbessern. Das Konditionierungsmittel kann im Reiniger, in einem gesonderten Bad danach oder im "Pre-dip" (Bad vor der Bekeimung) appliziert werden. Am zweckmäßigsten ist der Einsatz im Reiniger.

Bezüglich der Natur des Konditionierungsmittels wurden schon zahlreiche Vorschläge gemacht. So sieht die US-PS 3684572 die Verwendung einer oberflächenaktiven Substanz mit einer quaternären Aminogruppe vor. Die britische Patentanmeldung 2154251 beschreibt die Verwendung eines organischen Amin-Sensibilisierungsmittels, worunter gemäß den Beispielen insbesondere (2,3-Epoxipropyl)-trimethyl-ammoniumchlorid oder 2,3-Di-hydroxypropyl-trimethyl-ammoniumchlorid, gemäß der allgemeinen Formel aber auch gewisse niedermolekulare Derivate von Pyridin und Imidazol in quaternisierter Form zu verstehen sind. Die deutsche Offenlegungsschrift 3530617 schließlich offenbart als Konditionierungsmittel quaternisierte Heterocyclen wie Imidazol oder Benzimidazol, die am Stickstoffatom eine Vinyl- oder Allylgruppe besitzen. Die o.g. Konditionierungsmittel besitzen den Nachteil, daß ihre Adsorption an der Oberfläche des zu metallisierenden Materials nicht optimal ist und daß es sich in der letztgenannten Veröffentlichung um ethylenisch ungesättigte Monomere handelt, deren Handhabung aufgrund ihrer Toxizität besondere Sorgfalt erfordert.

Kationische Polymerisate, insbesondere solche, die ein Polyacrylamid-Rückgrad mit daran befestigten Tetraalkylammonium-Gruppen darstellen, werden als Konditioniermittel in der US-Patentschrift 4478883 empfohlen. Es hat sich gezeigt, daß Polymerisate dieser Art nur eine mäßige Wirkung haben.

Aufgabe der vorliegenden Erfindung ist es, Konditionierungsmittel zur Vorbehandlung nichtmetallischer Materialien für die nachfolgende Metallisierung zur Verfügung zu stellen, die eine optimale Haftung auf der Oberfläche aufweisen und bei sachgerechter Produktion mit einem Maximum an Sicherheit handhabbar sind.

Die gestellte Aufgabe wird erfüllt durch die Verwendung der in den Ansprüchen angeführten polymeren Konditionierungsmittel.

Die erfindungsgemäß zu verwendenden Stoffe sind bekannt bzw. können auf bekannte Weise erhalten werden, indem man Di- oder Tri-(hydroxyalkyl)-amine, insbesondere solche mit insgesamt bis zu 10 Kohlenstoffatomen in den Hydroxyalkylresten, oder deren Mischungen in Gegenwart von katalytischen Mengen von Lewis-Säuren bei erhöhter Temperatur unter Wasserabspaltung kondensiert und die so erhaltenen Kondensate in üblicher Weise quaternisiert, wobei man die Menge an Quaternisierungsmittel so wählt, daß der in den Ansprüchen angegebene Prozentsatz aller Stickstoffatome in den Polykondensaten quarternär wird.

Als Di- und Tri-(hydroxyalkyl)amine kommen beispielsweise in Betracht : Diethanolamin, Triethanolamin, Methyldiethanolamin, Butyldiethanolamin, Diisopropandiamin und Triisopropanolamin.

Vorzugsweise geht man von Diethanolamin, Triethanolamin und deren Mischungen aus. Als Katalysatoren für die Kondensation haben sich beispielsweise die folgenden Lewis-Säuren bewährt : Ameisensäure, Oxalsäure, Salze und Ester dieser Säuren ; phosphorige und unterphosphorige Säure und deren Ammonium- und Aminsalze ; Halogenide, Diester, Triester, Esteramide und Amide der phosphorigen Säure und der unterphosphorigen Säure. Bevorzugt werden phosphorige und unterphosphorige Säure. Die Katalysatoren werden zweckmäßigerweise in einer Menge von 0,1 bis 1,0 Gew.%, bezogen auf das zu kondensierende Amin, eingesetzt.

Als Kondensationstemperatur hat sich eine solche von etwa 120 bis 280°C bewährt.

Die so erhältlichen Polykondensate werden in einer zweiten Reaktionsstufe quaternisiert.

Die Quaternisierung kann in an sich bekannter Weise vorgenommen werden, wobei man die üblichen Quaternisierungsmittel, z.B. Alkyl- oder Benzylhalogenide, wie Butylbromid, Hexylbromide, Ethylhexylbromid, n-Octylbromid, n-Dodecylbromid, Benzylbromid oder die entsprechenden Chloride, einsetzt.

Nähere Angaben über die Herstellung der Polykondensate und ihre Quaternisierung finden sich beispielsweise in DE-OS 3537458, DE-AS-1127084 und DE-AS-1243874 (= britische Patentschrift 1116408).

Die Stickstoffatome der erfindungsgemäß zu verwendenden Polykondensate können zu 10 bis 99%, vorzugsweise zu 30 bis 90% und besonders bevorzugt zu 35 bis 80% mit $C_4$- bis $C_{12}$-Alkylgruppen und/oder Benzylgruppen quaternisiert sein unter der Bedingung, daß sie in dem wäßrigen Anwendungsbad löslich sind. Der erforderliche Grad der Löslichkeit hängt von der gewünschten Anwendungskonzentration ab. Eine Löslichkeit von wenigstens 1 Gew.% im Bad ist unter allen Umständen ausreichend und daher bevorzugt.

Art und Umfang der Quaternisierung beeinflussen aber nicht nur die Löslichkeit der Endprodukte, sondern auch ihre besondere Eignung im Zusammenwirken mit bestimmten Bekeimungskolloiden. Die im Anspruch 4 beschriebenen Polykondensate eignen sich sowohl zur Vorbehandlung vor einer Bekeimung mit Palladium-Kolloid, als auch vor einer Bekeimung mit Kupfer-Kolloid.

Die erfindungsgemäß zu verwendenden Polykondensate liegen als Quaternärsalze vor. Ihre quaternären Stickstoffatome können grundsätzlich durch beliebige Säureanionen kompensiert sein, sofern diese sich nicht auf die Löslichkeit der polymeren Salze negativ auswirken oder aufgrund eigener Reaktivität unerwünschte Störungen bei der Anwendung verursachen. In aller Regel enthalten die polymeren Salze der Einfachheit halber die aus den Quaternisierungsmitteln, die bei ihrer Herstellung eingesetzt worden sind, stammenden Anionen, also vorzugsweise Chlorid- und Bromid-Ionen.

Das Molekulargewicht der erfindungsgemäß zu verwendenden Polykondensate hat auf deren Wirkung keinen ausgeprägten Einfluß. Es kann davon ausgegangen werden, daß Molekulargewichte ab ca. 500 ausreichend sind. Die Verwendung besonders hochmolekularer Polykondensate bringt keine Vorteile. Molekulargewichte von 500 bis $2 \cdot 10^5$ sind bei der Polykondensation leicht zu erreichen und werden daher bevorzugt.

Die erfindungsgemäße Anwendung der oben beschriebenen polymeren Konditionierungsmittel geschieht in einem Bad, in welches der zu metallisierende Gegenstand — z.B. eine Leiterplatte — eingetaucht wird. Auch ein Besprühen des Gegenstandes mit der Lösung des Konditionierungsmittels ist möglich. Die Lösung des Konditionierungsmittels ist wäßrig, d.h. sie enthält als Lösemittel entweder nur Wasser oder überwiegend Wasser neben anderen mit Wasser mischbaren Flüssigkeiten, wie Alkoholen. Die Behandlung des nichtmetallischen Gegenstandes muß vor der Aktivierung durch das Palladium- oder Kupfer-Kolloid erfolgen, da sie sonst wirkungslos ist. Am zweckmäßigsten ist der Einsatz im Reinigungsbad. In den anderen Bädern besteht die Gefahr einer Schädigung des Konditionierungsmittels (z.B. im Ätzbad) oder einer Beeinträchtigung der Löslichkeit durch Salze (z.B. im "Pre-dip", einem Elektrolyte enthaltenden Bad). Der Einsatz in einem Spülbad wäre unökonomisch, ist aber grundsätzlich möglich.

Die benötigte Konzentration des Konditionierungsmittels beträgt 0,001 bis 1 Gew.%, vorzugsweise 0,005 bis 0,2 Gew.%. Die Bad-Temperatur sollte bevorzugt 20 bis 50°C betragen, die Dauer der Anwendung 15 Sec. bis 30 Min., bevorzugt 2 bis 10 Min..

Die erfindungsgemäß einzusetzenden Konditioniermittel kommen für die Vorbehandlung verschiedenster, chemisch zu metallisierender Materialien in Betracht, z.B. von Gegenständen aus Phenolharz/Papier, Epoxidharz, Polystyrol, Polyamid, Polyethylen, Polyvinylchlorid, Polycarbonaten, Polyacrylaten, Polyestern, Polysulfonen oder Polytetrafluorethylen, gegebenenfalls verstärkt oder gefüllt mit Glas, Mineralien oder Polymeren in gewebe-, faser- oder sonstiger Form, oder auch aus Glas oder keramischem Material.

Die folgenden Beispiele zeigen die Wirksamkeit der erfindungsgemäßen Verwendung der polymeren Konditionierungsmittel.

Bei der Prüfung wurde so vorgegangen, daß eine im Handel befindliche Chemisch-Kupfer-Produktlinie mit einer Palladium-Kolloid-Aktivierung und eine andere mit einer Kupfer-Kolloid-Aktivierung verwendet wurden. Die Produkt-Linien bestehen jeweils aus :

- Reiniger
- Ätzbad                    (Anätzung der Kupfer-Kaschierung)
- "Pre-dip"                 (Vorbehandlung zur Kolloid-Bekeimung)
- Aktivator                 (Pd- bzw. Cu-Kolloid)
- Stripper                  (Entfernung von Kolloid-Überschuß)
- Chemisch-Kupfer-Bad       (Abscheidungs-Bad).

Die jeweils zwischengeschalteten Spülbäder sind in dieser Aufstellung nicht enthalten. Das Konditionierungsmittel wurde jeweils dem Reiniger-Bad in einer Konzentration von 0,15 Gew.% zugesetzt. Die einzelnen Bäder hatten ein Volumen von je 50 ml (Reagenzglas im thermostatisierten Wasserbad). Die Temperaturen, die Behandlungsdauern und die Spülungen zwischen den Bädern entsprachen den Vorschriften der Hersteller. Als Substrate wurden verwendet :

— Glasfaser-Gewebestücke, Gewebeart Atlas, Flächengewicht 296 g/m², am Rand mit handelsüblichem Klebstoff fixiert.

— Streifen von glasfaserverstärkten Epoxidharz-Leiterplatten, "FR4" (entsprechend Military Standard Mil-P-13949E, Klasse GFGF), beidseitig mit Kupferfolie kaschiert und gebohrt.

Die Substrate wurden während der Behandlung im Bad leicht bewegt.

Die Glasfaser-Gewebestücke wurden jeweils 10 Min. im Abscheidungsbad behandelt. Nach Durchlaufen des letzten Spülbades wurden sie in Isopropanol getaucht und dann mit Preßluft getrocknet.

Die Leiterplatten-Stücke wurden in der mit Palladium-Kolloid arbeitenden Produktlinie 9 Min., in der mit Kupfer-Kolloid arbeitenden 7 Min. im Abscheidungsbad belassen und dann mit Preßluft getrocknet. Dabei wird eine dünne Verkupferung mit relativ vielen Fehlstellen (Löchern) erhalten, die jedoch Einflüsse des Konditionierungsmittels sehr gut erkennen läßt. Die Prüfung der Verkupferung der Bohrlöcher der Leiterplatten-Stücke erfolgte anhand von Schliffpräparaten, die unter dem Mikroskop im Durchlicht abgemustert wurden. Diese Methode wird u.a. beschrieben im Jahrbuch Oberflächentechnik 40, 1984, S. 122-133 (H.-J. Ehrich : "Vorteile der alkalischen Aktivierung zur Herstellung hochwertiger Leiterplatten").

Die Beurteilung der verkupferten Substrate erfolgte nach Noten :

| Note | Beurteilung |  |
|------|-------------|--|
| 0 | keine Abscheidung | |
| 1 | sehr mangelhaft | (nur partielle Abscheidung) |
| 2 | mangelhaft | (erheblicher Lichtdurchtritt) |
| 3 | mäßig | |
| 4 | befriedigend | (f. Produktion noch geeignet) |
| 5 | gut | (wenig Löcher bzw. Lichtdurchtritt) |
| 6 | sehr gut | (keine Löcher bzw. Lichtdurchtritt) |

Es sei hier nochmals darauf hingewiesen, daß sich durch die absichtlich vorgenommene dünne Verkupferung bei der Prüfung der Leiterplatten-Stücke schlechte Absolut-Noten ergeben. Die Wirkung der Konditionierungsmittel ergibt sich hier aus der Noten-Differenz.

Es wurde folgendes polymeres Konditionierungsmittel geprüft :

I  Kondensat aus Di- und Triethanolamin (Molverhältnis 1 : 1),

quaternisiert zu 80%, bez. auf N, mit Benzylchlorid, das durch Kondensation der o.g. Amine bei 210°C während 7 Stunden in Gegenwart von Unterphosphoriger Säure und anschließende Quaternisierung in 70 Gew.% Wasser/30 Gew.% Ethanol bei 25°C während 6 Stunden hergestellt worden waren. Das Ethanol war nach der Quaternisierung durch Destillation entfernt worden.

| Bsp. Nr. | Konditionie- rungsmittel | Kolloid Pd | Cu | Substrat Glas L.-Pl. | | Note | Wirkung = Noten-Diff. |
|---|---|---|---|---|---|---|---|
| Vgl. 1 | - | X | | X | | 3 | - |
| 1 | I | X | | X | | 4-5 | 1,5 |
| Vgl. 2 | - | | X | X | | 3-4 | - |
| 2 | I | | X | X | | 6 | 2,5 |
| Vgl. 3 | - | | X | | X | 2-3 | - |
| 3 | I | | X | | X | 4 | 1,5 |

In einer weiteren Versuchsreihe wurde wie oben angegeben gearbeitet, nur wurde statt des in den Beispielen 1 bis 4 und den Vergleichsbeispielen 1 bis 3 verwendeten, zur Produktlinie gelieferten Reinigerbades ein solches folgender Zusammensetzung eingesetzt :

$$1,5 \text{ Gew.\%} \quad \text{Nonylphenol-ethoxylat (14EO)}$$
$$0,6 \text{ Gew.\%} \quad \text{Triethanolamin}$$
$$0,02 \text{ Gew.\%} \quad \text{Polyvinylpyrrolidon mit dem K-Wert 30}$$
$$0,04 \text{ Gew.\%} \quad \text{Natriumhydrogenphosphat}$$
$$\text{Rest bis 100} \quad \text{Gew.\% Wasser}$$

diesem Bad wurde im Vergleichsbeispiel 4 kein Konditionierungsmittel, in den Vergleichsbeispielen 5 und 6 und dem erfindungsgemäßen Beispiel 4 jeweils 0,5 Gew.% folgendes Konditionierungsmittel eingesetzt :

Vgl. 5 : II.  Copolymerisat aus 30 Gew.% Acrylamid und 70 Gew.% (2-Acryloyloxyethyl)-trimethylammoniumchlorid (entsprechend US-Patentschrift 4478883) ;

Vgl. 6 : III.  Copolymerisat aus 50 Gew.% Acrylamid und 50 Gew.% (2-Acryloyloxyethyl)-trimethylammoniumchlorid (entsprechend US-Patentschrift 4478883) ;

Bsp. 4 : IV.  Kondensat, hergestellt analog dem oben genannten Produkt I, jedoch quaternisiert zu 80%, bezogen auf N, mit n-Octylbromid.

Die Abscheidungszeit im Chemisch-Kupfer-Bad betrug 15 Minuten.

Aus der folgenden Tabelle ist ersichtlich, daß das gemäß der Erfindung durchgeführte Beispiel 4 wesentlich bessere Ergebnisse liefert als die nach der Lehre der US-Patentschrift 4478883 durchgeführten Vergleichsbeispiele 5 und 6.

| Bsp. Nr. | Konditionie- rungsmittel | Kolloid Pd | Substrat Glas | Note | Wirkung = Noten-Diff. |
|---|---|---|---|---|---|
| Vgl. 4 | - | X | X | 0-1 | - |
| Vgl. 5 | II | X | X | 1 | 0,5 |
| Vgl. 6 | III | X | X | 1-2 | 1 |
| 4 | IV | X | X | 3-4 | 3 |

**Patentansprüche**

1. Verwendung von in wäßrigem Anwendungsbad löslichen quaternären Salzen von Di- und/oder Tri-(hydroxyalkyl)-amin-Polykondensaten, deren Stickstoffatome zu 10 bis 99% mit $C_4$- bis $C_{12}$-Alkylgruppen und-/oder Benzylgruppen quaternisiert sind, als Konditionierungsmittel zur Vorbehandlung nichtmetallischer Oberflächen vor ihrer Bekeimung für eine nachfolgende chemische Metallisierung.

2. Verwendung gemäß Anspruch 1, dadurch gekennzeichnet, daß die Stickstoffatome der Polykondensate zu 30 bis 90% quaternisiert sind.

3. Verwendung gemäß Anspruch 1 oder 2, dadurch gekennzeichnet, daß es sich im Polykondensate aus Di- und/oder Triethanolamin handelt.

4. Verwendung gemäß einem der Ansprüche 1 bis 3, dadurch gekennzeichnet, daß die Stickstoffatome der Polykondensate zu 35 bis 80% mit n-Octyl- oder Benzylgruppen quaternisiert sind.

5. Verwendung von quaternären Salzen gemäß einem der Ansprüche 1 bis 4 in einem wäßrigen Anwendungsbad in einer Konzentration von 0,001 bis 1 Gew.% bei einer Badtemperatur von 10 bis 60°C und einer Anwendungszeit von 15 Sekunden bis 30 Minuten.


**Claims**

1. Use of quaternary salts of di- and/or tri(hydroxyalkyl)-amine polycondensates which are soluble in the aqueous bath used and from 10 to 99% of whose nitrogen atoms are quaternized with $C_4$-$C_{12}$-alkyl groups and/or benzyl groups, as conditioners for pre-treating nonmetallic surfaces prior to their activation for subsequent chemical metallization.

2. Use as claimed in claim 1, wherein from 30 to 90% of the nitrogen atoms of the polycondensates are quaternized.

3. Use as claimed in claim 1 or 2, wherein the polycondensates are polycondensates of di- and/or triethanolamine.

4. Use as claimed in any of claims 1 to 3, wherein from 35 to 80% of the nitrogen atoms of the polycondensates are quaternized with n-octyl or benzyl groups.

5. Use of a quaternary salt as claimed in any of claims 1 to 4 in an aqueous application bath in a concentration of from 0.001 to 1% by weight at a bath temperature of from 10 to 60°C and for from 15 seconds to 30 minutes.


**Revendications**

1. Utilisation de sels quaternaires, solubles dans le bain aqueux d'application, de produits de polycondensation de di- et/ou de tri-(hydroxyalkyl)-amines dont les atomes d'azote sont quaternisés à raison de 10 à 99% avec des groupements alkyle en $C_4$ à $C_{12}$ et/ou des groupements benzyle, comme agents de conditionnement pour le pré-traitement de surfaces non métalliques avant leur ensemencement en vue d'une métallisation chimique subséquente.

2. Utilisation selon la revendication 1, caractérisée en ce que les atomes d'azote des produits de polycondensation sont quaternisés à raison de 30 à 90%.

3. Utilisation selon la revendication 1 ou 2, caractérisée en ce qu'il s'agit de produits de polycondensation de di- et/ou de triéthanolamine.

4. Utilisation selon l'une quelconque des revendications 1 à 3, caractérisée en ce que les atomes d'azote des produits de polycondensation sont quaternisés à raison de 35 à 80% avec des groupements n-octyle ou benzyle.

5. Utilisation de sels quaternaires selon l'une quelconque des revendications 1 à 4 dans un bain aqueux d'application à une concentration de 0,001 à 1% en poids, à une température du bain de 10 à 60°C et avec une durée d'application de 15 s à 30 mn.